# EUROPEAN PATENT SPECIFICATION

(11) **EP 4 050 216 B1**
(45) Date of publication and mention of the grant of the patent: **22.01.2025**
(21) Application number: 22153824.2
(22) Date of filing: 28.01.2022
(51) Int. Cl.: F04D 19/04, F04B 37/14, F04C 25/02, F04D 27/02

(54) **VACUUM EXHAUST METHOD AND VACUUM EXHAUST SYSTEM**
VERFAHREN UND SYSTEM ZUR VAKUUMABSAUGUNG
PROCÉDÉ ET SYSTÈME D'ÉVACUATION À VIDE

(30) Priority: 26.02.2021 JP 2021029379
(43) Date of publication of application: 31.08.2022
(73) Proprietor: EBARA CORPORATION, Ota-ku, Tokyo 144-8510 (JP)
(72) Inventor: SASAKI, Shinichiro, Tokyo, 1448510 (JP); HOZUMI, Takashi, Tokyo, 1448510 (JP); SHIOKAWA, Atsushi, Tokyo, 1448510 (JP)
(74) Representative: Carstens, Dirk Wilhelm

(56) References cited:
- JP-A- 2003 090 287
- US-A- 4 835 114
- US-A1- 2015 086 387
- US-A1- 2017 350 397

## Description

### BACKGROUND OF THE INVENTION

### Field of the Invention:

The present invention relates to a vacuum exhaust method and a vacuum exhaust system.

### Description of the Related Art:

A vacuum pump apparatus for exhausting a gas in a vacuum chamber is known in order to maintain the vacuum chamber of a semiconductor manufacturing apparatus (e.g., an etching apparatus or a chemical vapor deposition apparatus (CVD)) in a vacuum state.

The gas for a film deposition (process gas) supplied to the vacuum chamber may include a gas that generates by-product. In this case, when the vacuum pump apparatus exhausts the gas in the vacuum chamber, there is a risk that the by-product may flow into the vacuum pump apparatus along with the gas, or that the by-product may be generated in the vacuum pump apparatus.

Reference is made to JP 10-252651 A and JP 2004-29346 A. Attention is also drawn to US 2015 086 387 A1, which is related to a method and an apparatus for warming up a vacuum pump arrangement. In the method, a booster pump and a backing pump are set to a first and a second speeds, respectively. In one embodiment, the backing pressure of the booster pump is monitored and if it is outside a predetermined range, inert gas is injected into the outlet of the booster pump. Furthermore, the temperature of the booster pump is monitored and once it has reached a threshold temperature, the inert gas injection is stopped.

The by-product is produced depending on temperature and pressure. For example, the by-product is likely to form at high pressures (and/or low temperature). Therefore, as a means for suppressing a formation of the by-product, a method of reducing the pressure of the gas supplied into the vacuum pump apparatus can be considered. An example of this method is an introduction of an inert gas into the vacuum pump apparatus to dilute a concentration of the gas.

However, in such a method, more gas is introduced into the vacuum pump apparatus. Therefore, the power consumption for driving the vacuum pump apparatus becomes large, and a rotational speed of the vacuum pump apparatus may stagnate before reaching a rated rotational speed (rated rotational speed). As a result, there may be a problem that it takes a long time to start up the vacuum pump apparatus or the rotational speed of the vacuum pump apparatus does not reach the rated rotational speed.

### SUMMARY OF THE INVENTION

It is therefore an object of the present invention to provide a vacuum exhaust method and a vacuum exhaust system capable of solving problems associated with the introduction of the inert gas while suppressing the formation of the by-product.

In accordance with the present invention, a vacuum exhaust method and a vacuum exhaust system as set forth in claims 1 and 7, respectively, are provided. Further embodiments are inter alia disclosed in the dependent claims

In particular , there is provided a vacuum exhaust method of exhausting a vacuum chamber by a vacuum pump apparatus, comprising: an increasing step of increasing a rotational speed of the vacuum pump apparatus to a predetermined stable speed after starting the vacuum pump apparatus; and a gas introduction step of introducing an inert gas into the vacuum pump apparatus after the rotational speed of the vacuum pump apparatus reaches the stable speed and the vacuum exhaust method further comprises: a first introduction step of introducing the inert gas of a first flow rate comprising a zero flow rate into the vacuum pump apparatus through a bypass line branched from an inert gas supply line connected to the vacuum pump apparatus; and a second introduction step of introducing the inert gas of a second flow rate larger than the first flow rate into the vacuum pump apparatus.

In an embodiment, the stable speed comprises a first stable speed when an inverter output at a current rotational speed of the vacuum pump apparatus becomes larger than a shaft output of the vacuum pump apparatus, and the gas introduction step is performed after the rotational speed of the vacuum pump apparatus reaches the first stable speed.

In an embodiment, the stable speed comprises a second stable speed when the rotational speed of the vacuum pump apparatus is a rated rotational speed, and the gas introduction step is performed after the rotational speed of the vacuum pump apparatus reaches the second stable speed.

In an embodiment, the vacuum exhaust method comprises a gas heating step of heating the inert gas through an inert gas supply line connected to the vacuum pump apparatus.

In an embodiment, the vacuum pump exhaust method comprises an opening operation step of opening an on-off valve attached to an inert gas supply line connected to the vacuum pump apparatus in the gas introduction step.

There is also provided a vacuum exhaust system comprising: a vacuum pump apparatus configured to exhaust a vacuum chamber; a gas introduction apparatus configured to introduce an inert gas into the vacuum pump apparatus, the gas introduction apparatus comprising a bypass line branched from an inert gas supply line and connected to the vacuum pump apparatus; and a flow rate controller configured to control a flow rate of the inert gas introduced into the vacuum pump apparatus through the bypass line; and a controller configured to control an operation of the vacuum pump apparatus and an operation of the gas introduction apparatus, the controller is configured to: increase a rotational speed of the vacuum pump apparatus to a predetermined stable speed after starting the vacuum pump apparatus; introduce the inert gas into the vacuum pump apparatus by controlling the gas introduction apparatus after the rotational speed of the vacuum pump apparatus reaches the stable speed; perform a first introduction step of introducing the inert gas of a first flow rate into the vacuum pump apparatus through the flow rate controller; and perform a second introduction step of introducing the inert gas of a second flow rate larger than the first flow rate after the first introduction step is performed and the rotational speed of the vacuum pump apparatus reaches the stable speed.

In an embodiment, the stable speed comprises a first stable speed when an inverter output at a current rotational speed of the vacuum pump apparatus becomes larger than a shaft output of the vacuum pump apparatus, and the controller is configured to control the gas introduction apparatus to introduce the inert gas into the vacuum pump apparatus after the rotational speed of the vacuum pump apparatus reaches the first stable speed.

In an embodiment, the stable speed comprises a second stable speed when the rotational speed of the vacuum pump apparatus is a rated rotational speed, and the controller is configured to control the gas introduction apparatus to introduce the inert gas into the vacuum pump apparatus after the rotational speed of the vacuum pump apparatus reaches the second stable speed.

In an embodiment, the gas introduction apparatus comprises: an inert gas supply line connected to the vacuum pump apparatus; and a gas heating structure configured to heat the inert gas through the inert gas supply line.

In an embodiment, the gas heating structure is a heater configured to heat the inert gas supply line.

In an embodiment, the gas heating structure is a pump casing heated by a compression heat on an exhaust port side of the vacuum pump apparatus.

In an embodiment, the gas introduction apparatus comprises an on-off valve configured to open and close an inert gas supply line, and the controller is configured to control an opening/closing operation of the on-off valve.

In an embodiment, the gas introduction apparatus comprises a flow rate sensor configured to detect a flow rate of the inert gas flowing through an inert gas supply line, and the controller is configured to determine a state of an on-off valve based on a flow rate signal sent from the flow rate sensor.

In an embodiment, the gas introduction apparatus comprises a combination of an on-off valve configured to open and close an inert gas supply line and a flow rate sensor configured to detect a flow rate of the inert gas flowing through the inert gas supply line.

In an embodiment, the flow rate controller comprises an on-off valve configured to open and close the bypass line.

In an embodiment, the flow rate controller comprises a flow rate adjustment valve or an orifice attached to the bypass line.

The vacuum exhaust method is a method of introducing the inert gas into the vacuum pump apparatus after the rotational speed of the vacuum pump apparatus reaches a stable speed. Therefore, the vacuum exhaust method can not only suppress the generation of the by-product, but also shorten the time required for the start-up of the vacuum pump apparatus. Further, there is no problem that the rotational speed of the vacuum pump apparatus does not reach the rated rotational speed.

### BRIEF DESCRIPTION OF THE DRAWINGS

FIG. 1 is a view showing an example of a vacuum exhaust system;
FIG. 2 is a view showing an operation flow of a controller;
FIG. 3 is a view showing a timing of opening and closing an on-off valve;
FIG. 4 is a view for explaining a first stable speed;
FIG. 5 is a view showing an embodiment of the invention of a gas introduction apparatus;
FIG. 6 is a view showing another embodiment of the gas introduction apparatus;
FIG. 7 is a view showing still another embodiment of the gas introduction apparatus;
FIG. 8 is a view showing an optional feature of the gas introduction apparatus;
FIG. 9 is a view showing still another optional feature of the gas introduction apparatus;
FIG. 10 is a view showing still another optional feature of the gas introduction apparatus; and
FIG. 11 is a view showing another embodiment of a gas heating structure.

### DESCRIPTION OF EMBODIMENTS

Embodiments will be described with reference to the drawings.

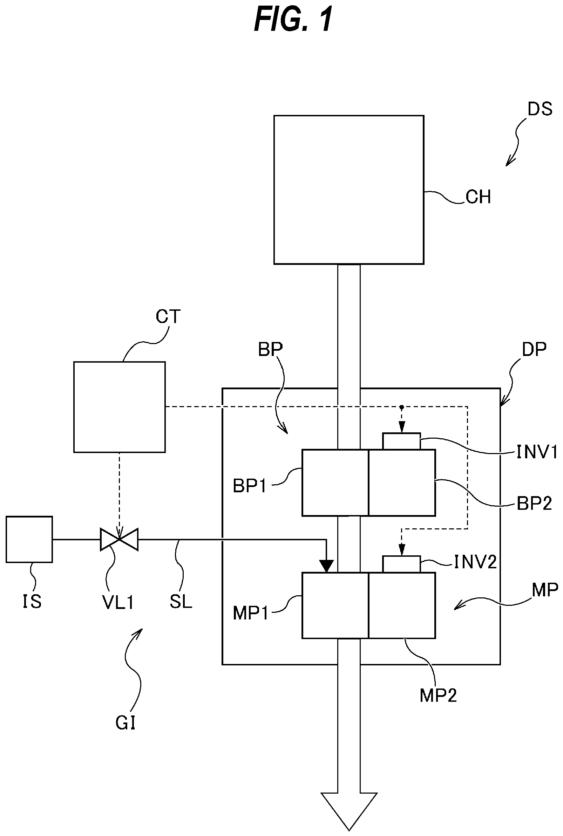

FIG. 1 is a view showing an example of a vacuum exhaust system which is not according to the invention, but which is useful to understand aspects thereof.

As shown in FIG. 1, the vacuum exhaust system DS includes a vacuum pump apparatus DP that exhausts a vacuum chamber CH for performing processing such as etching and film deposition in a semiconductor manufacturing process, a gas introduction apparatus GI that introduces an inert gas (e.g., N₂ gas) into the vacuum pump apparatus DP, and a controller CT that controls an operation of the vacuum pump apparatus DP and an operation of the gas introduction apparatus GI.

The vacuum chamber CH constitutes a part of a semiconductor manufacturing apparatus (not shown), and a process gas including a gas that produces by-product is introduced into the vacuum chamber CH. The vacuum pump apparatus DP is connected to the vacuum chamber CH. The vacuum pump apparatus DP exhausts the vacuum chamber CH by driving the vacuum pump apparatus DP. The process gas is sucked into the vacuum pump apparatus DP by exhausting the vacuum chamber CH.

In the example shown in FIG. 1, the vacuum pump apparatus DP includes two vacuum pump apparatuses (i.e., a booster pump apparatus BP and a main pump apparatus MP). The booster pump apparatus BP includes a booster pump BP1, a motor BP2 for driving the booster pump BP1, and an inverter INV1 which is a variable speed means of the motor BP2. Similarly, the main pump apparatus MP includes a main pump MP1, a motor MP2 for driving the main pump MP1, and an inverter INV2 which is a variable speed means of the motor MP2. In one embodiment, the vacuum pump apparatus DP may include a single pump apparatus or may include three or more vacuum pump apparatuses.

The gas introduction apparatus GI is connected to the vacuum pump apparatus DP. As shown in FIG. 1, the gas introduction apparatus GI includes an inert gas supply line SL connected to the main pump MP1 of the main pump apparatus MP, a gas supply source IS for supplying the inert gas through the inert gas supply line SL to the main pump apparatus MP, and an on-off valve VL1 for opening and closing the inert gas supply line SL. The inert gas supply line SL may be connected to the booster pump BP1 of the booster pump apparatus BP. Alternatively, the inert gas supply line SL may be connected to both the booster pump BP1 and the main pump MP1.

The controller CT is electrically connected to the on-off valve VL1 and controls an opening and closing operation of the on-off valve VL1. An example of the on-off valve VL1 includes an electromagnetic valve. When the controller CT closes the on-off valve VL1, the on-off valve VL1 shuts off a supply of the inert gas from the gas supply source IS to the main pump MP1. When the controller CT opens the on-off valve VL1, the on-off valve VL1 allows the supply of the inert gas from the gas supply source IS to the main pump MP1.

The controller CT is electrically connected to each of the inverter INV1 and the inverter INV2, and controls a driving operation of the motor BP2 and the motor MP2. In other words, the controller CT controls the operation of the booster pump apparatus BP and the main pump apparatus MP through the motor BP2 and the motor MP2. In the present specification, the booster pump apparatus BP and the main pump apparatus MP may be collectively referred to as a vacuum pump apparatus DP.

When the vacuum chamber CH is exhausted, the process gas including the gas that produces the by-product is sucked into the vacuum pump apparatus DP. As described above, the by-product is produced depending on the pressure (and temperature). Therefore, in order to suppress the formation of the by-product, the gas introduction apparatus GI introduces the inert gas into the vacuum pump apparatus DP to reduce the pressure of the process gas.

However, if the inert gas is introduced from the start-up of the vacuum pump apparatus DP, the power consumption of the vacuum pump apparatus DP may increase, and the rotational speed of the vacuum pump apparatus DP may stagnate without increasing. As a result, the vacuum pump apparatus DP may take a long time to start up and the rotational speed of the vacuum pump apparatus DP may not reach the rated rotation speed.

Therefore, the controller CT increases the rotational speed of the vacuum pump apparatus DP to a predetermined stable speed after starting the vacuum pump apparatus DP, and controls the gas introduction apparatus GI to introduce the inert gas into the vacuum pump apparatus DP after the rotational speed of the vacuum pump apparatus DP reaches the stable speed.

The controller CT does not introduce the inert gas from the start-up of the vacuum pump apparatus DP until the rotational speed of the vacuum pump apparatus DP reaches a stable speed, and introduces the inert gas into the vacuum pump apparatus DP after the rotational speed of the vacuum pump apparatus DP reaches the stable speed. By such an operation, the controller CT can smoothly bring the rotational speed of the vacuum pump apparatus DP to the rated rotational speed without consuming unnecessary power when the vacuum pump apparatus DP starts up. As a result, the vacuum exhaust system DS can shorten a rise time of the vacuum pump apparatus DP. Further, by such an operation, the vacuum exhaust system DS can realize a reduction of the amount of the inert gas used.

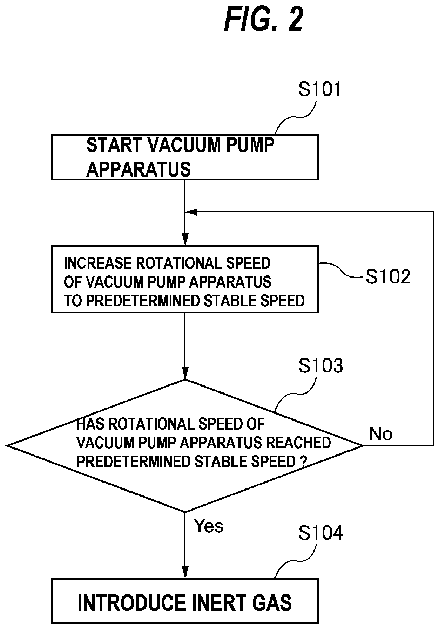

FIG. 2 is a view showing an operation flow of the controller. As shown in step S101 of FIG. 2, first, the controller CT starts the vacuum pump apparatus DP. Thereafter, as shown in step S 102, the rotational speed of the vacuum pump apparatus DP is increased to a predetermined stable speed. The step of increasing the rotational speed is referred to as an increasing step. The controller CT determines the rotational speed of the vacuum pump apparatus DP based on an electric power (i.e., electric current, electric voltage) supplied to the vacuum pump apparatus DP.

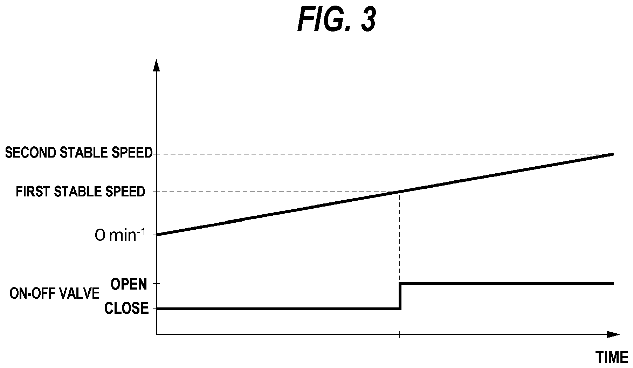

FIG. 3 is a view showing a timing of opening and closing the on-off valve. As shown in FIG. 3, the predetermined stable speed includes a first stable speed and a second stable speed larger than the first stable speed. The first stable speed is a speed at which an inverter output (electric power) at a current rotational speed of the vacuum pump apparatus DP becomes larger than a shaft output of the vacuum pump apparatus DP. The second stable speed is a speed when the rotational speed of the vacuum pump apparatus DP is the rated rotational speed.

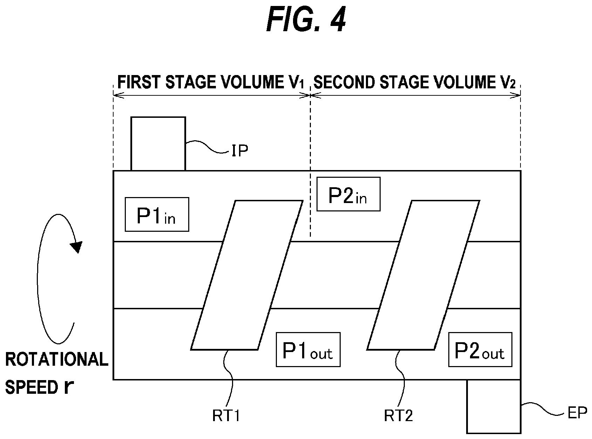

FIG. 4 is a view for explaining the first stable speed. As shown in FIG. 4, a volume between an intake port IP and a first stage rotor RT1 is defined as a first stage volume Vi, and a volume between an exhaust port EP and a second stage rotor RT2 is defined as a second stage volume V₂. The shaft output is a total output of a compression power (Wc) and a mechanical loss (F) generated when the rotor rotates. The compression power (Wc) can be expressed by the following mathematical formula. Compression power (Wc) = Σ (volume Vi of each stage × rotational speed r × pressure difference Pi of each stage)

For example, as shown in FIG. 4, the compression power (Wc) can be expressed by the following mathematical formula. Compression power (Wc) = first stage volume V₁ × rotational speed r × (P1ₒᵤₜ - P1ᵢₙ) + V₂× r × (P2ₒᵤₜ - P2ᵢₙ)

The mechanical loss (F) is mainly caused by a friction of the components (e.g., timing gear, bearing) of the vacuum pump apparatus DP, and the mechanical loss (F) increases in proportion to the rotational speed of the vacuum pump apparatus DP.

As shown in step S 103 of FIG. 2, the controller CT determines whether or not the rotational speed of the vacuum pump apparatus DP has reached the predetermined stable speed (first stable speed or second stable speed) after performing step S 102. If the rotational speed of the vacuum pump apparatus DP has not reached the predetermined stable speed (see "No" in step S103), the controller CT continues step S102. At this time, the controller CT continues the closing operation of the on-off valve VL1.

When the rotational speed of the vacuum pump apparatus DP reaches the predetermined stable speed (see "Yes" in step S103), as shown in step S104, the controller CT opens the on-off valve VL1 to introduce the inert gas to the pump apparatus DP. This step of introducing the inert gas is referred to as a gas introduction step.

As shown in FIG. 3, the controller CT opens the on-off valve VL1 of the gas introduction apparatus GI to introduce the inert gas into the vacuum pump apparatus DP after the rotational speed of the vacuum pump apparatus DP reaches the first stable speed. In one embodiment, the first stable speed is determined to be a rotational speed (about 60% of the second stable speed (i.e., the rated rotational speed)) at which a performance on an exhaust side of the vacuum pump apparatus DP is sufficiently ensured and the rotational speed does not stagnate.

In one embodiment, the controller CT opens the on-off valve VL1 of the gas introduction apparatus GI after the rotational speed of the vacuum pump apparatus DP reaches the second stable speed (i.e., rated rotational speed) to introduce the inert gas into the vacuum pump apparatus DP.

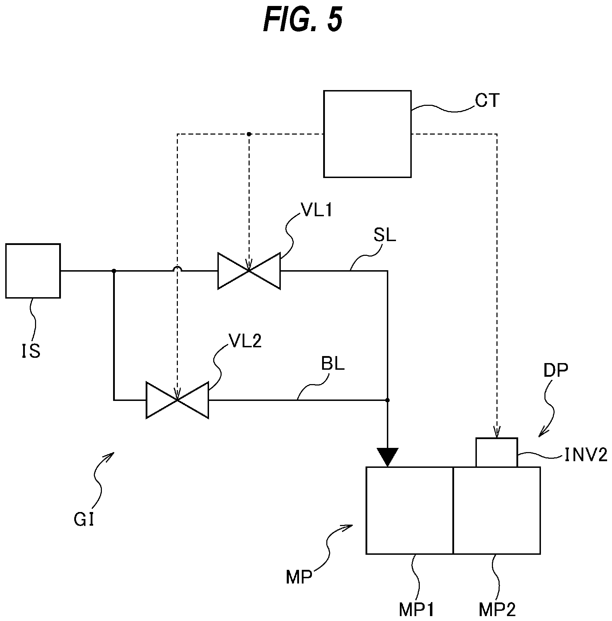

FIG. 5 is a view showing an embodiment of the gas introduction apparatus.
As shown in FIG. 5, the gas introduction apparatus GI includes a bypass line BL branched from the inert gas supply line SL and connected to the vacuum pump apparatus DP, a flow rate controller for controlling a flow rate of the inert gas introduced into the vacuum pump apparatus DP through the bypass line BL.

In the embodiment shown in FIG. 5, the flow rate controller includes an on-off valve VL2 that opens and closes the bypass line BL. The controller CT is electrically connected to the on-off valve VL2 and controls the opening/closing operation of the on-off valve VL2. The on-off valve VL2 may have the same configuration as the on-off valve VL1. An example of the on-off valve VL2 includes an electromagnetic valve.

The bypass line BL has a cross-sectional area smaller than that of the inert gas supply line SL. By such a structure, the inert gas of the flow rate (first flow rate) passing through the bypass line BL is smaller than the inert gas of the flow rate (second flow rate) passing through the inert gas supply line SL. The first flow rate may include a zero flow rate. The zero flow rate blocks the passage of the inert gas through the bypass line BL. Therefore, when the on-off valve VL2 is in the closed state, the flow rate of the inert gas passing through the bypass line BL is zero. When the on-off valve VL2 is in the open state, the flow rate of the inert gas passing through the bypass line BL is larger than zero and smaller than the second flow rate.

In the embodiment shown in FIG. 5, the controller CT performs a first introduction step of introducing the inert gas of the first flow rate into the vacuum pump apparatus DP through the bypass line BL in the increasing step. In one embodiment, the first introduction step may be started immediately after the start of the vacuum pump apparatus DP. In the first introduction step, the on-off valve VL1 is maintained in the closed state.

After performing the first introduction step, the controller CT introduces the inert gas of the second flow rate larger than the first flow rate into the vacuum pump apparatus DP in the gas introduction step (second introduction step). In the second introduction step, the controller CT switches the on-off valve VL1 from the closed state to the open state. At this time, the controller CT may close or open the on-off valve VL2. By opening the on-off valve VL2, a larger flow rate of the inert gas can be introduced into the vacuum pump apparatus DP.

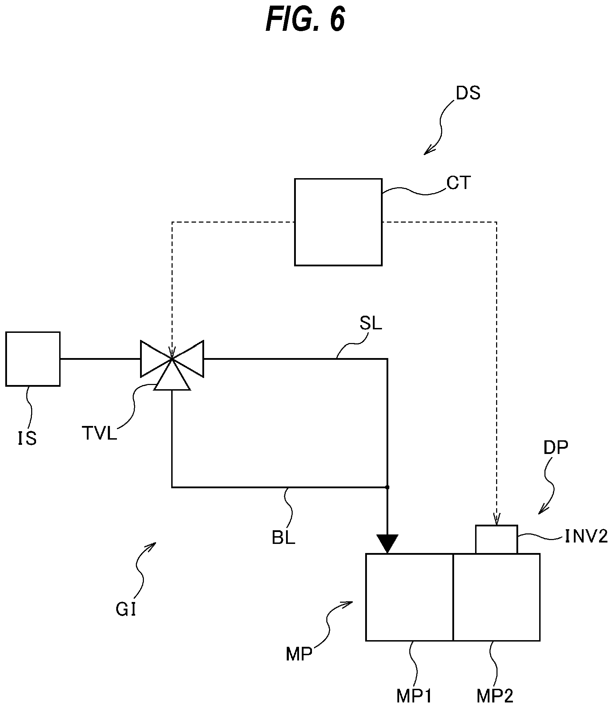

FIG. 6 is a view showing another embodiment of the gas introduction apparatus. As shown in FIG. 6, the gas introduction apparatus GI may include a three-way valve TVL as a flow rate controller instead of the on-off valve VL1 and the on-off valve VL2. In the embodiment shown in FIG. 6, the three-way valve TVL corresponds to the on-off valve VL1 and the on-off valve VL2.

As shown in FIG. 6, the controller CT is electrically connected to the three-way valve TVL and controls a switching operation of the three-way valve TVL. More specifically, the controller CT operates (i.e., first operates) the three-way valve TVL to connect an upstream side and a downstream side of the inert gas supply line SL. In this case, the gas supply source IS and the vacuum pump apparatus DP are coupled through the inert gas supply line SL. The controller CT operates (i.e., second operates) the three-way valve TVL to connect the upstream side of the inert gas supply line SL and the bypass line BL. In this case, the gas supply source IS and the vacuum pump apparatus DP are coupled through the bypass line BL.

The vacuum exhaust system DS in the embodiment shown in FIG. 6 can also exert the same effect as the vacuum exhaust system DS in the embodiment shown in FIG. 5. Therefore, in the increasing step, the controller CT second operates the three-way valve TVL to introduce the inert gas of the first flow rate (zero flow rate in the embodiment shown in FIG. 6) into the vacuum pump apparatus DP through the bypass line BL. In the gas introduction step, the controller CT first operates the three-way valve TVL to introduce the inert gas of the second flow rate into the vacuum pump apparatus DP through the inert gas supply line SL.

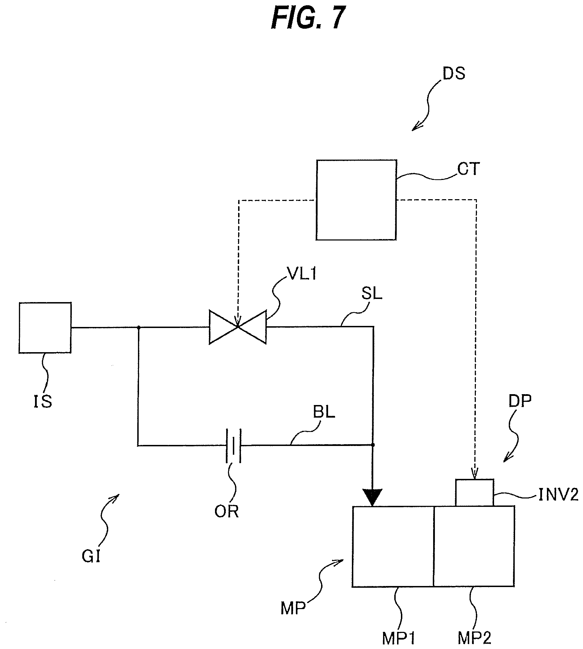

FIG. 7 is a view showing still another embodiment of the gas introduction apparatus. As shown in FIG. 7, the flow rate controller may include an orifice OR attached to the bypass line BL. In the embodiment shown in FIG. 7, the controller CT closes the on-off valve VL1 in the increasing step to introduce the inert gas of the first flow rate (in the embodiment shown in FIG. 7, the flow rate larger than zero flow rate) into the vacuum pump apparatus DP through the bypass line BL. In the gas introduction step, the controller CT opens the on-off valve VL1 and introduces the inert gas of the second flow rate into the vacuum pump apparatus DP through the inert gas supply line SL. At this time, the inert gas of the first flow rate is introduced into the vacuum pump apparatus DP through the bypass line BL.

Although not shown, the flow rate controller may include a flow rate adjustment valve instead of the orifice OR. Further, if necessary, the embodiment shown in FIG. 5, the embodiment shown in FIG. 6, and the embodiment shown in FIG. 7 may be appropriately combined. For example, the flow rate controller may include the on-off valve VL2 shown in FIG. 5, the three-way valve TVL shown in FIG. 6, and the orifice OR (or the flow rate adjustment valve) shown in FIG. 7.

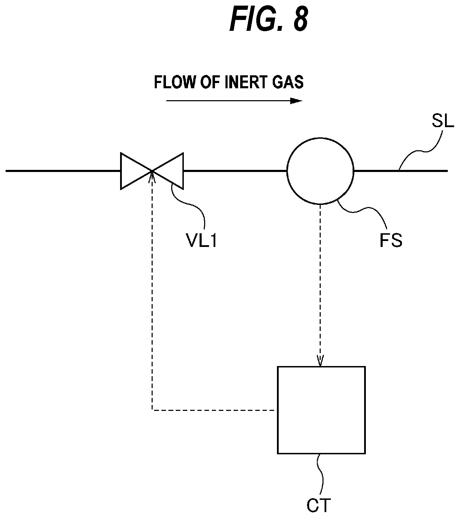

FIG. 8 is a view showing a detail of the gas introduction apparatus. As shown in FIG. 8, the gas introduction apparatus GI may further include a flow rate sensor FS that detects the flow rate of the inert gas flowing through the inert gas supply line SL. The flow rate sensor FS is arranged on the downstream side of the on-off valve VL1 in the flow direction of the inert gas.

The controller CT is electrically connected to the flow rate sensor FS and measures the flow rate of the inert gas passing through the flow rate sensor FS based on a flow rate signal sent from the flow rate sensor FS. As shown in FIG. 8, the controller CT can determine a state (more specifically, an abnormality) of the on-off valve VL1 based on the flow rate signal sent from the flow rate sensor FS. For example, when the flow rate of the inert gas passing through the flow rate sensor FS is larger than a predetermined threshold value (first threshold value) in the increasing step, the controller CT determines the abnormality of the on-off valve VL1. Similarly, in the gas introduction step, when the flow rate of the inert gas passing through the flow rate sensor FS is smaller than a predetermined threshold value (second threshold value), the controller CT may determine the abnormality of the on-off valve.

In this manner, the controller CT can determine the abnormality of the on-off valve VL1 based on the flow rate signal sent from the flow rate sensor FS. When the controller CT determines the abnormality of the on-off valve VL1, the controller CT may issue an alarm. Although not shown, the flow rate sensor FS may be attached to the bypass line BL (see FIGS. 5, 6, and 7).

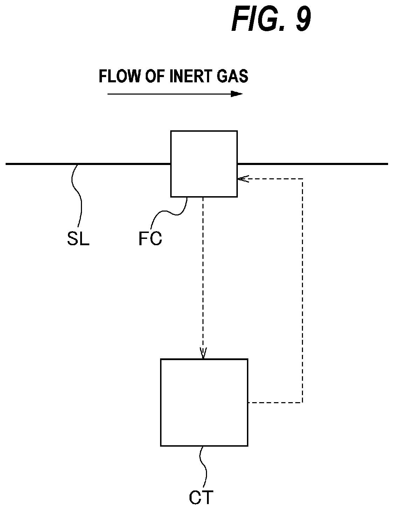

FIG. 9 is a view showing another detail of the gas introduction apparatus. As shown in FIG. 9, the gas introduction apparatus GI may include a mass flow rate sensor FC. The mass flow rate sensor FC is a combination of the on-off valve VL1 and the flow rate sensor FS. As shown in FIG. 9, the mass flow rate sensor FC has a structure in which an on-off valve is built in the flow rate sensor. The controller CT is electrically connected to the mass flow sensor FC. The controller CT operates the mass flow rate sensor FC to control the opening/closing operation of the inert gas supply line SL, and can measure the flow rate of the inert gas passes through the mass flow rate sensor FC based on the flow rate signal sent from the mass flow rate sensor FC.

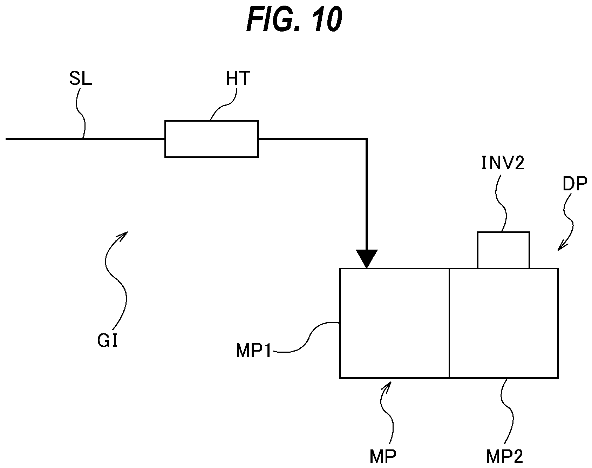

FIG. 10 is a view showing still another detail of the gas introduction apparatus. As shown in FIG. 10, the gas introduction apparatus GI may include a gas heating structure that heats the inert gas through the inert gas supply line SL. As described above, the by-product is produced depending not only on the pressure but also on the temperature. Therefore, the gas introduction apparatus GI may include the gas heating structure in order to suppress the formation of the by-product. When the inert gas heated by the gas heating structure is supplied to the vacuum pump apparatus DP, the temperature drop of the process gas is suppressed. In other words, the temperature of the process gas is raised. As a result, the production of the by-products is suppressed.

As shown in FIG. 10, the gas heating structure is a heater HT that heats the inert gas supply line SL. The heater HT heats the inert gas supply line SL, and the inert gas passing through the heated inert gas supply line SL becomes hot. As a result, the high-temperature inert gas is supplied to the vacuum pump apparatus DP, and the production of the by-products is suppressed. The step of heating the inert gas is referred to as a gas heating step.

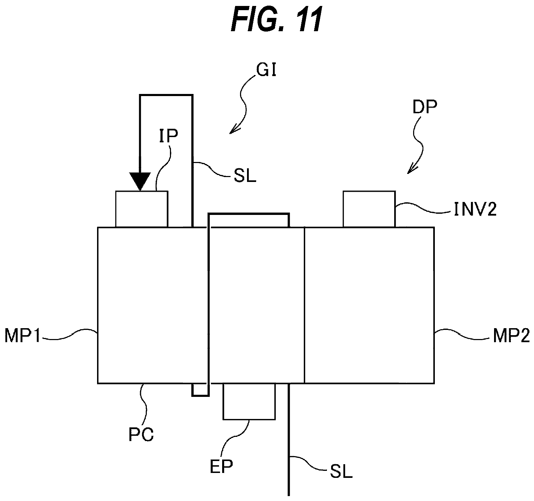

FIG. 11 is a view showing another embodiment of the gas heating structure. As shown in FIG. 11, the gas heating structure is a pump casing PC heated by a compression heat on the exhaust port EP side of the vacuum pump apparatus DP (in the embodiment shown in FIG. 11, the main pump apparatus MP). When the gas is compressed and discharged by driving the vacuum pump apparatus DP, the pump casing PC (particularly, the exhaust port EP side) generates heat and becomes hot. Therefore, the inert gas supply line SL is arranged so as to come into contact with the pump casing PC.

In the embodiment shown in FIG. 11, the inert gas supply line SL is wound around the pump casing PC. With such an arrangement, the inert gas supply line SL is heated by the heat of the pump casing PC, and the inert gas passing through the heated inert gas supply line SL becomes hot. As a result, the high-temperature inert gas is supplied to the vacuum pump apparatus DP, and the production of by-products is suppressed.

The features shown in FIG. 10 and shown in FIG. 11 may be combined. In this case, the gas heating structure has a heater HT attached to the inert gas supply line SL and a structure in which the inert gas supply line SL is wound around the pump casing PC.

The previous description is provided to enable a person skilled in the art to make and use the present invention. Moreover, various modifications will be readily apparent to those skilled in art. Therefore, the present invention is not intended to be limited to the embodiments described herein but is to be accorded the widest scope as defined by limitation of the claims.

## Claims

1. A vacuum exhaust method of exhausting a vacuum chamber (CH) by a vacuum pump apparatus (DP), comprising:
an increasing step (S102) of increasing a rotational speed of the vacuum pump apparatus (DP) to a predetermined stable speed after starting the vacuum pump apparatus (DP);
a gas introduction step (S104) of introducing an inert gas into the vacuum pump apparatus (DP) after the rotational speed of the vacuum pump apparatus (DP) reaches the stable speed; and wherein the vacuum exhaust method comprises:
a first introduction step of introducing inert gas of a first flow rate into the vacuum pump apparatus (DP) through a bypass line (BL) branched from an inert gas supply line (SL) connected to the vacuum pump apparatus (DP); and
a second introduction step of introducing inert gas of a second flow rate larger than the first flow rate into the vacuum pump apparatus (DP).

2. The method according to claim 1, wherein the stable speed comprises a first stable speed when an inverter output at a current rotational speed of the vacuum pump apparatus (DP) becomes larger than a shaft output of the vacuum pump apparatus (DP), and
the gas introduction step is performed after the rotational speed of the vacuum pump apparatus (DP) reaches the first stable speed.

3. The method according to claim 1, the stable speed comprises a second stable speed when the rotational speed of the vacuum pump apparatus (DP) is a rated rotational speed, and
the gas introduction step is performed after the rotational speed of the vacuum pump apparatus (DP) reaches the second stable speed.

4. The method according to any one of claims 1 to 3, wherein the vacuum exhaust method comprises a gas heating step of heating the inert gas through an inert gas supply line (SL) connected to the vacuum pump apparatus (DP).

5. The method according to any one of claims 1 to 4, wherein the vacuum pump exhaust method comprises an opening operation step of opening an on-off valve (VL1) attached to an inert gas supply line (SL) connected to the vacuum pump apparatus (DP) in the gas introduction step.

6. The method according to any one of claims 1 to 5, wherein the vacuum exhaust method comprises blocking the passage of the inert gas through the bypass line (BL) during the second introduction step.

7. A vacuum exhaust system (DS) comprising:
a vacuum pump apparatus (DP) configured to exhaust a vacuum chamber (CH);
a gas introduction apparatus (GI) configured to introduce an inert gas into the vacuum pump apparatus (DP), the gas introduction apparatus (GI) comprising: an inert gas supply line (SL) connected to the vacuum pump apparatus (DP),
a bypass line (BL) branched from the inert gas supply line (SL) and connected to the vacuum pump apparatus (DP), and
a flow rate controller (VL2; TVL; OR) configured to control a flow rate of the inert gas introduced into the vacuum pump apparatus (DP) through the bypass line (BL), and
a controller (CT) configured to control an operation of the vacuum pump apparatus (DP) and an operation of the gas introduction apparatus (GI),
wherein the controller (CT) is configured to:
increase a rotational speed of the vacuum pump apparatus (DP) to a predetermined stable speed after starting the vacuum pump apparatus (DP); and
introduce inert gas into the vacuum pump apparatus (DP) by controlling the gas introduction apparatus (GI) after the rotational speed of the vacuum pump apparatus (DP) reaches the stable speed;
perform a first introduction step of introducing inert gas of a first flow rate into the bypass line (BL) of the vacuum pump apparatus (DP) through the flow rate controller (VL2; TVL; OR); and
perform a second introduction step of introducing inert gas of a second flow rate larger than the first flow rate after the first introduction step is performed and the rotational speed of the vacuum pump apparatus reaches the stable speed.

8. The vacuum exhaust system (DS) according to claim 7, wherein the stable speed comprises a first stable speed when an inverter output at a current rotational speed of the vacuum pump apparatus (DP) becomes larger than a shaft output of the vacuum pump apparatus (DP), and
wherein the controller (CT) is configured to control the gas introduction apparatus (GI) to introduce the inert gas into the vacuum pump apparatus (DP) after the rotational speed of the vacuum pump apparatus (DP) reaches the first stable speed.

9. The vacuum exhaust system (DS) according to claim 7, wherein the stable speed comprises a second stable speed when the rotational speed of the vacuum pump apparatus (CT) is a rated rotational speed, and
wherein the controller (CT) is configured to control the gas introduction apparatus (GI) to introduce the inert gas into the vacuum pump apparatus (DP) after the rotational speed of the vacuum pump apparatus (DP) reaches the second stable speed.

10. The vacuum exhaust system (DS) according to any one of claims 7 to 9, wherein the gas introduction apparatus (GI) comprises:
a gas heating structure configured to heat the inert gas through the inert gas supply line (SL).

11. The vacuum exhaust system (DS) according to claim 10, wherein the gas heating structure is a heater (HT) configured to heat the inert gas supply line (SL).

12. The vacuum exhaust system (DS) according to claim 10 or 11, wherein the gas heating structure is a pump casing heated by a compression heat on an exhaust port side of the vacuum pump apparatus (DP).

13. The vacuum exhaust system (DS) according to any one of claims 7 to 12, wherein the gas introduction apparatus (GI) comprises an on-off valve (VL1) or a three-way valve (TVL) configured to open and close the inert gas supply line (SL), and
wherein the controller is configured to control an opening/closing operation of the on-off valve ((VL1) or the three-way valve (TVL).

14. The vacuum exhaust system (DS) according to any one of claims 7 to 13, wherein the gas introduction apparatus (GI) comprises a flow rate sensor (FS) configured to detect a flow rate of the inert gas flowing through the inert gas supply line (SL), and
wherein the controller is configured to determine a state of an on-off valve (VL1) based on a flow rate signal sent from the flow rate sensor (FS).

15. The vacuum exhaust system (DS) according to any one of claims 7 to 14, wherein the gas introduction apparatus (GI) comprises a combination (FC) of an on-off valve configured to open and close an inert gas supply line and a flow rate sensor configured to detect a flow rate of the inert gas flowing through the inert gas supply line (SL).

16. The vacuum exhaust system (DS) according to any one of claims 7 to 15, wherein the bypass line (BL) has a cross-sectional area smaller than that of the inert gas supply line (SL).

17. The vacuum exhaust system (DS) according to claim 16, wherein the flow rate controller (VL2) comprises an on-off valve or a three-way valve configured to open and close the bypass line (BL).

18. The vacuum exhaust system (DS) according to claim 16 or 17, wherein the flow rate controller (OR) comprises a flow rate adjustment valve or an orifice attached to the bypass line (BL).

## Patentansprüche

1. Vakuumabsaugverfahren zum Absaugen einer Vakuumkammer (CH) durch eine Vakuumpumpenvorrichtung (DP), aufweisend:
einen Erhöhungsschritt (S102) zum Erhöhen einer Drehzahl der Vakuumpumpenvorrichtung (DP) auf eine vorbestimmte stabile Drehzahl nach dem Starten der Vakuumpumpenvorrichtung (DP);
einen Gaseinleitungsschritt (S104) zum Einleiten eines Inertgases in die Vakuumpumpenvorrichtung (DP), nachdem die Drehzahl der Vakuumpumpenvorrichtung (DP) die stabile Drehzahl erreicht hat; und wobei das Vakuumabsaugverfahren Folgendes aufweist:
einen ersten Einleitungsschritt des Einleitens von Inertgas mit einer ersten Durchflussrate in die Vakuumpumpenvorrichtung (DP) durch eine Bypass-Leitung (BL), die von einer mit der Vakuumpumpenvorrichtung (DP) verbundenen Inertgas-Zuführleitung (SL) abzweigt; und
einen zweiten Einleitungsschritt des Einleitens von Inertgas mit einer zweiten Durchflussrate, die größer als die erste Durchflussrate ist, in die Vakuumpumpenvorrichtung (DP).

2. Verfahren gemäß Anspruch 1, wobei die stabile Drehzahl eine erste stabile Drehzahl aufweist, wenn eine Wechselrichterausgabe bei einer aktuellen Drehzahl der Vakuumpumpenvorrichtung (DP) größer wird als eine Wellenausgabe der Vakuumpumpenvorrichtung (DP), und
der Gaseinleitungsschritt durchgeführt wird, nachdem die Drehzahl der Vakuumpumpenvorrichtung (DP) die erste stabile Drehzahl erreicht.

3. Das Verfahren gemäß Anspruch 1, wobei die stabile Drehzahl eine zweite stabile Drehzahl aufweist, wenn die Drehzahl der Vakuumpumpenvorrichtung (DP) eine Nenndrehzahl ist, und
der Gaseinleitungsschritt durchgeführt wird, nachdem die Drehzahl der Vakuumpumpenvorrichtung (DP) die zweite stabile Drehzahl erreicht hat.

4. Verfahren gemäß einem der Ansprüche 1 bis 3, wobei das Vakuumabsaugverfahren einen Gaserwärmungsschritt aufweist, bei dem das Inertgas durch eine mit der Vakuumpumpenvorrichtung (DP) verbundene Inertgas-Zuführleitung (SL) erwärmt wird.

5. Verfahren gemäß einem der Ansprüche 1 bis 4, wobei das Vakuumpumpen-Absaugverfahren einen Öffnungsarbeitsgang des Öffnens eines Ein-Aus-Ventils (VL1) aufweist, das an einer Inertgas-Zuführleitung (SL) angebracht ist, die mit der Vakuumpumpenvorrichtung (DP) im Gaseinleitungsschritt verbunden ist.

6. Verfahren gemäß einem der Ansprüche 1 bis 5, wobei das Vakuumabsaugverfahren das Blockieren des Durchgangs des Inertgases durch die Bypass-Leitung (BL) während des zweiten Einführungsschritts aufweist.

7. Vakuumabsaugsystem (DS), aufweisend:
eine Vakuumpumpenvorrichtung (DP), die konfiguriert ist zum Absaugen einer Vakuumkammer (CH);
eine Gaseinleitungsvorrichtung (GI), die konfiguriert ist zum Einleiten eines Inertgases in die Vakuumpumpenvorrichtung (DP), wobei die Gaseinleitungsvorrichtung (GI) ,Folgendes aufweist:
eine Inertgas-Zuführleitung (SL), die mit der Vakuumpumpenvorrichtung (DP) verbunden ist,
eine Bypass-Leitung (BL), die von der Inertgas-Zuführleitung (SL) abzweigt und mit der Vakuumpumpenvorrichtung (DP) verbunden ist, und
einen Durchflussregler (VL2; TVL; OR), der konfiguriert ist zum Steuern einer Durchflussrate des Inertgases, das durch die Bypass-Leitung (BL) in die Vakuumpumpenvorrichtung (DP) eingeleitet wird, und
eine Steuereinheit (CT), die konfiguriert ist zum Steuern eines Betriebs der Vakuumpumpenvorrichtung (DP) und eines Betriebs der Gaseinleitungsvorrichtung (GI),
wobei die Steuereinheit (CT) konfiguriert ist zum:
Erhöhen der Drehzahl der Vakuumpumpenvorrichtung (DP) nach dem Starten der Vakuumpumpenvorrichtung (DP) auf eine vorbestimmte stabile Drehzahl; und
Einleiten von Inertgas in die Vakuumpumpenvorrichtung (DP) durch Steuern der Gaseinleitungsvorrichtung (GI), nachdem die Drehzahl der Vakuumpumpenvorrichtung (DP) die stabile Drehzahl erreicht hat;
Durchführen eines ersten Einleitungsschritts zum Einleiten von Inertgas mit einer ersten Durchflussrate in die Bypass-Leitung (BL) der Vakuumpumpenvorrichtung (DP) durch den Durchflussratenregler (VL2; TVL; OR); und
Durchführen eines zweiten Einleitungsschritts zum Einleitens von Inertgas mit einer zweiten Durchflussrate, die größer ist als die erste Durchflussrate, nachdem der erste Einleitungsschritt durchgeführt wurde und die Drehzahl der Vakuumpumpenvorrichtung die stabile Drehzahl erreicht hat.

8. Vakuumabsaugsystem (DS) gemäß Anspruch 7, wobei die stabile Drehzahl eine erste stabile Drehzahl aufweist, wenn ein Wechselrichterausgang bei einer aktuellen Drehzahl der Vakuumpumpenvorrichtung (DP) größer wird als eine Wellenausgabe der Vakuumpumpenvorrichtung (DP), und
wobei die Steuerung (CT) konfiguriert ist zum Steuern der Gaseinleitungsvorrichtung (GI) zum Einleiten des Inertgases in die Vakuumpumpenvorrichtung (DP) nachdem die Drehzahl der Vakuumpumpenvorrichtung (DP) die erste stabile Drehzahl erreicht hat.

9. Vakuumabsaugsystem (DS) gemäß Anspruch 7, wobei die stabile Drehzahl eine zweite stabile Drehzahl aufweist, wenn die Drehzahl der Vakuumpumpenvorrichtung (CT) eine Nenndrehzahl ist, und
wobei die Steuerung (CT) konfiguriert ist zum Steuern der Gaseinleitungsvorrichtung (GI) zum Einleiten des Inertgases in die Vakuumpumpenvorrichtung (DP) nachdem die Drehzahl der Vakuumpumpenvorrichtung (DP) die zweite stabile Drehzahl erreicht hat.

10. Vakuumabsaugsystem (DS) gemäß einem der Ansprüche 7 bis 9, wobei die Gaseinleitungsvorrichtung (GI) Folgendes aufweist:
eine Gasheizstruktur, die konfiguriert ist zum Erwärmen des Inertgases durch die Inertgas-Zuführleitung (SL).

11. Vakuumabsaugsystem (DS) gemäß Anspruch 10, wobei die Gasheizstruktur eine Heizvorrichtung (HT) ist, die konfiguriert ist zum Erwärmen der Inertgas-Zuführleitung (SL).

12. Vakuumabsaugsystem (DS) gemäß Anspruch 10 oder 11, wobei die Gasheizstruktur ein Pumpengehäuse ist, das durch Kompressionswärme auf einer Auslassöffnungsseite der Vakuumpumpenvorrichtung (DP) erwärmt wird.

13. Vakuumabsaugsystem (DS) gemäß einem der Ansprüche 7 bis 12, wobei die Gaseinleitungsvorrichtung (GI) ein Ein/Aus-Ventil (VL1) oder ein Dreiwegeventil (TVL) aufweist, das konfiguriert ist zum Öffnen und Schließen der Inertgas-Zuführleitung (SL), und
wobei die Steuerung konfiguriert ist zum Steuern eines Öffnungs-/Schließvorgangs des Ein/Aus-Ventils (VL1) oder des Dreiwegeventils (TVL).

14. Vakuumabsaugsystem (DS) gemäß einem der Ansprüche 7 bis 13, wobei die Gaseinleitungsvorrichtung (GI) einen Durchflusssensor (FS) aufweist, der konfiguriert ist zum Detektieren einer Durchflussrate des durch die Inertgas-Zuführleitung (SL) strömenden Inertgases, und
wobei die Steuerung konfiguriert ist zum Bestimmen eines Zustands eines Ein-Aus-Ventils (VL1) auf der Grundlage eines vom Durchflusssensor (FS) gesendeten Durchflusssignals.

15. Vakuumabsaugsystem (DS) gemäß einem der Ansprüche 7 bis 14, wobei die Gaseinleitungsvorrichtung (GI) eine Kombination (FC) aus einem Ein-Aus-Ventil, das zum Öffnen und Schließen einer Inertgas-Zuführleitung konfiguriert ist, und einem Durchflussratensensor, der zum Detektieren einer Durchflussrate des durch die Inertgas-Zuführleitung (SL) strömenden Inertgases konfiguriert ist, aufweist.

16. Das Vakuumabsaugsystem (DS) gemäß einem der Ansprüche 7 bis 15, wobei die Bypass-Leitung (BL) eine Querschnittsfläche aufweist, die kleiner ist als die der Inertgas-Zuführleitung (SL).

17. Das Vakuumabsaugsystem (DS) gemäß Anspruch 16, wobei der Durchflussregler (VL2) ein Ein/Aus-Ventil oder ein Dreiwegeventil aufweist, das konfiguriert ist zum Öffnen und Schließen der Bypass-Leitung (BL).

18. Das Vakuumabsaugsystem (DS) gemäß Anspruch 16 oder 17, wobei der Durchflussregler (OR) ein Durchflussregelventil oder eine an der Bypass-Leitung (BL) angebrachte Zumessöffnung aufweist.

## Revendications

1. Procédé d'évacuation sous vide de mis sous vide d'une chambre à vide (CH) par un appareil à pompe à vide (DP), comprenant :
une étape d'accroissement (S102) d'augmentation d'une vitesse de rotation de l'appareil de pompe à vide (DP) jusqu'à une vitesse stable prédéterminée après le démarrage de l'appareil de pompe à vide (DP) ;
une étape d'introduction de gaz (S104) d'introduction d'un gaz inerte dans l'appareil de pompe à vide (DP) après que la vitesse de rotation de l'appareil de pompe à vide (DP) a atteint la vitesse stable ; et dans lequel le procédé d'évacuation sous-vide comprend :
une première étape d'introduction d'introduction du gaz inerte à un premier débit dans l'appareil de pompe à vide (DP) par l'intermédiaire d'une conduite de dérivation (BL) dérivée d'une conduite d'alimentation en gaz inerte (SL) connectée à l'appareil de pompe à vide (DP) ; et
une deuxième étape d'introduction d'introduction du gaz inerte à un deuxième débit supérieur au premier débit dans l'appareil de pompe à vide.

2. Procédé selon la revendication 1, dans lequel la vitesse stable comprend une première vitesse stable lorsqu'une sortie d'onduleur à une vitesse de rotation actuelle de l'appareil de pompe à vide (DP) devient plus grande qu'une sortie d'arbre de l'appareil de pompe à vide (DP), et
l'étape d'introduction de gaz est effectuée après que la vitesse de rotation de l'appareil de pompe à vide (DP) atteint la première vitesse stable.

3. Procédé selon la revendication 1, la vitesse stable comprend une deuxième vitesse stable lorsque la vitesse de rotation de l'appareil de pompe à vide (DP) est une vitesse de rotation nominale, et
l'étape d'introduction de gaz est effectuée après que la vitesse de rotation de l'appareil de pompe à vide (DP) a atteint la deuxième vitesse stable.

4. Procédé selon l'une quelconque des revendications 1 à 3, dans lequel le procédé d'évacuation sous vide comprend une étape de chauffage de gaz consistant à chauffer le gaz inerte à travers une conduite d'alimentation en gaz inerte (SL) connectée à l'appareil de pompe à vide (DP).

5. Procédé selon l'une quelconque des revendications 1 à 4, dans lequel le procédé d'évacuation de pompe à vide comprend une étape d'opération d'ouverture d'ouverture d'une vanne d'arrêt (VL1) fixée à une conduite d'alimentation en gaz inerte (SL) connectée à l'appareil de pompe à vide (DP) dans l'étape d'introduction de gaz.

6. Procédé selon l'une quelconque des revendications 1 à 5, dans lequel le procédé d'évacuation sous vide comprend le blocage du passage du gaz inerte dans la conduite de dérivation (BL) pendant la deuxième étape d'introduction.

7. Système d'évacuation sous vide (DS) comprenant :
un appareil de pompe à vide (DP) configuré pour évacuer une chambre à vide (CH) ;
un appareil d'introduction de gaz (GI) configuré pour introduire un gaz inerte dans l'appareil de pompe à vide (DP), l'appareil d'introduction de gaz (GI) comprenant :
une conduite d'alimentation en gaz inerte (SL) connectée à l'appareil de pompe à vide (DP),
une conduite de dérivation (BL) dérivée de la conduite d'alimentation en gaz inerte (SL) et connectée à l'appareil de pompe à vide (DP), et
un contrôleur de débit (VL2 ; TVL ; OR) configuré pour contrôler un débit du gaz inerte introduit dans l'appareil de pompe à vide (DP) au moyen de la conduite de dérivation (BL), et
un contrôleur (CT) configuré pour contrôler le fonctionnement de l'appareil de pompe à vide (DP) et le fonctionnement de l'appareil d'introduction de gaz (GI),
dans lequel le contrôleur (CT) est configuré pour :
augmenter une vitesse de rotation de l'appareil de pompe à vide (DP) jusqu'à une vitesse stable prédéterminée après le démarrage de l'appareil de pompe à vide (DP) ; et
introduire le gaz inerte dans l'appareil de pompe à vide (DP) en contrôlant l'appareil d'introduction de gaz (GI) après que la vitesse de rotation de l'appareil de pompe à vide (DP) a atteint la vitesse stable ;
effectuer une première étape d'introduction d'introduction du gaz inerte à un premier débit dans la conduite de dérivation (BL) de l'appareil de pompe à vide (DP) au moyen du contrôleur de débit (VL2 ; TVL ; OR) ; et
effectuer une deuxième étape d'introduction d'introduction du gaz inerte à un deuxième débit supérieur au premier débit après l'exécution de la première étape d'introduction et que la vitesse de rotation de l'appareil de pompe à vide a atteint la vitesse stable.

8. Système d'évacuation sous vide (DS) selon la revendication 7, dans lequel la vitesse stable comprend une première vitesse stable lorsqu'une sortie d'onduleur à une vitesse de rotation actuelle de l'appareil de pompe à vide (DP) devient plus grande qu'une sortie d'arbre de l'appareil de pompe à vide (DP), et
dans lequel le contrôleur (CT) est configuré pour contrôler l'appareil d'introduction de gaz (GI) pour introduire le gaz inerte dans l'appareil de pompe à vide (DP) après que la vitesse de rotation de l'appareil de pompe à vide (DP) a atteint la première vitesse stable.

9. Système d'évacuation sous vide (DS) selon la revendication 7, dans lequel la vitesse stable comprend une deuxième vitesse stable lorsque la vitesse de rotation de l'appareil de pompe à vide (CT) est une vitesse de rotation nominale, et
dans lequel le contrôleur (CT) est configuré pour commander l'appareil d'introduction de gaz (GI) pour introduire le gaz inerte dans l'appareil de pompe à vide (DP) après que la vitesse de rotation de l'appareil de pompe à vide (DP) a atteint la deuxième vitesse stable.

10. Système d'évacuation sous vide (DS) selon l'une quelconque des revendications 7 à 9, dans lequel l'appareil d'introduction de gaz (GI) comprend :
une structure de chauffage au gaz configurée pour chauffer le gaz inerte à travers la conduite d'alimentation en gaz inerte (SL).

11. Système d'évacuation sous vide (DS) selon la revendication 10, dans lequel la structure de chauffage de gaz est un élément chauffant (HT) configuré pour chauffer la conduite d'alimentation en gaz inerte (SL).

12. Système d'évacuation sous vide (DS) selon la revendication 10 ou 11, dans lequel la structure de chauffage de gaz est un boîtier de pompe chauffé par une chaleur de compression sur un côté d'orifice d'évacuation de l'appareil de pompe à vide (DP) .

13. Système d'évacuation sous vide (DS) selon l'une quelconque des revendications 7 à 12, dans lequel l'appareil d'introduction de gaz (GI) comprend une vanne d'arrêt (VL1) ou une vanne à trois voies (TVL) configurée pour ouvrir et fermer la conduite d'alimentation en gaz inerte (SL), et
dans lequel le contrôleur est configuré pour contrôler une opération d'ouverture/fermeture de la vanne d'arrêt (VL1) ou de la vanne à trois voies (TVL).

14. Système d'évacuation sous vide (DS) selon l'une quelconque des revendications 7 à 13, dans lequel l'appareil d'introduction de gaz (GI) comprend un capteur de débit (FS) configuré pour détecter un débit du gaz inerte s'écoulant à travers la conduite d'alimentation en gaz inerte (SL), et
dans lequel le contrôleur est configuré pour déterminer un état d'une vanne d'arrêt (VL1) sur la base d'un signal de débit envoyé par le capteur de débit (FS).

15. Système d'évacuation sous vide (DS) selon l'une quelconque des revendications 7 à 14, dans lequel l'appareil d'introduction de gaz (GI) comprend une association (FC) d'une vanne d'arrêt configurée pour ouvrir et fermer une conduite d'alimentation en gaz inerte et un capteur de débit configuré pour détecter un débit du gaz inerte s'écoulant à travers la conduite d'alimentation en gaz inerte (SL).

16. Système d'évacuation sous vide (DS) selon l'une quelconque des revendications 7 à 15, dans lequel la conduite de dérivation (BL) a une surface transversale plus petite que la conduite d'alimentation en gaz inerte (SL).

17. Système d'évacuation sous vide (DS) selon la revendication 16 ou 17, dans lequel le contrôleur de débit (VL2) comprend une vanne d'arrêt ou une vanne à trois voies configurée pour ouvrir et fermer la conduite de dérivation (BL).

18. Système d'évacuation sous vide (DS) selon la revendication 16, dans lequel le contrôleur de débit (OR) comprend une vanne de réglage de débit ou un orifice fixé à la conduite de dérivation (BL).
